# EUROPEAN PATENT APPLICATION

(11) **EP 4 657 581 A1**
(43) Date of publication of application: **03.12.2025**
(21) Application number: 25179935.9
(22) Date of filing: 30.05.2025
(51) Int. Cl.: H01M 10/04, H01M 50/209, H01M 50/251, H01M 50/264, H01M 50/291

(54) **BATTERY AND POWER COMPONENT RESTRAINTS WITHIN FRONT ACCESS ENCLOSURES**

(30) Priority: 31.05.2024 US 202463654436 P
(71) Applicant: Vertiv Corporation, Westerville, OH 43082 (US)
(72) Inventor: MALONEY, Jerome Andrew, Sugar Grove (US); ELKINS, Jin Harrison, Auburn (US)
(74) Representative: Beal, James Michael

(57) **Abstract**

A shelf sub-assembly (400) configured to accommodate a battery or power component upon installation is disclosed. The shelf sub-assembly comprises: a shelf body (410) comprising a two-sided configuration where a first side (412) of the shelf body is perpendicular to a second side (414) of the shelf body and the first side is attachable to an interior of a power component and battery enclosure and where the second side extends horizontally relative to the first side when the first side is attached to the interior of the power component and battery enclosure and provides a level surface upon which a bottom surface of the battery or a bottom surface of a power component is placed when installed; and a leaf spring component (404) attachable to the first side of the shelf body and comprising a radiused surface (406) configured to apply a compressive force against the battery or power component when installed.

## Description

### CROSS REFERENCE TO RELATED APPLICATIONS

This Patent Application claims the benefit of and priority to U.S. Provisional Patent Application Serial No. 63/654,436 filed May 31, 2024.

### FIELD

The following description relates to battery and power component enclosure assemblies, and in particular to battery and power component restraints within front access enclosures.

### BACKGROUND

Power component and battery enclosures are essential for protecting battery or power components from environmental factors and mechanical stresses. Traditional power component and battery enclosures often face challenges with accommodating battery or power components of varying dimensions and ensuring their secure attachment with the power component and battery enclosure is compliant with different standards. This can lead to issues such as inefficient use of space, increased complexity of assembly, and potential for mechanical failure due to improper mounting.

### SUMMARY

An aspect of the disclosed embodiments includes a shelf sub-assembly configured to accommodate a battery or power component upon installation. The shelf sub-assembly comprises a shelf body comprising a two-sided configuration where a first side of the shelf body is perpendicular to a second side of the shelf body and the first side and the second side intersect at a first edge of the first side and a second edge of the second side, where the first side is attachable to an interior of a power component and battery enclosure, and where the second side extends substantially horizontally relative to the first side when the first side is attached to the interior of the power component and battery enclosure and provides a substantially level surface upon which a bottom surface of a battery or a bottom surface of a power component is placed when installed. The shelf sub-assembly further comprises a leaf spring component attachable to the first side of the shelf body, where the leaf spring component comprises a radiused surface configured to engage a lateral surface of the battery or power component and apply a compressive force against the lateral surface when the battery or power component is installed.

Another aspect of the disclosed embodiments includes a system for securing a battery or power component within a battery and power component enclosure. The system comprises a first shelf sub-assembly comprising a first shelf body comprising a two-sided configuration where a first side of the first shelf body is perpendicular to a second side of the first shelf body, where the first side of the first shelf body is attachable to a first interior side of the power component and battery enclosure, and where the second side of the first shelf body extends substantially horizontally relative to the first side of the first shelf body when the first side of the first shelf body is attached to the first interior side and provides a substantially level surface upon which a bottom surface of a battery or a bottom surface of a power component is placed when installed. The system further comprises a first leaf spring component attachable to the first side of the first shelf body, where the first leaf spring component comprises a first radiused surface configured to apply a first compressive force against a first lateral surface of the battery or power component when the battery or power component is installed and a second shelf sub-assembly. The second shelf body comprises a two-sided configuration where a first side of the second shelf body is perpendicular to a second side of the second shelf body, where the first side of the second shelf body is attachable to a second interior side of the power component and battery enclosure, and where the second side of the second shelf body extends substantially horizontally relative to the first side of the second shelf body when the first side of the second shelf body is attached to the second interior side and provides a substantially level surface upon which the bottom surface of the battery or the bottom surface of the power component is placed when installed. The second shelf body further comprises a second leaf spring component attachable to the first side of the second shelf body, where the second leaf spring component comprises a second radiused surface configured to apply a second compressive force against a second lateral surface of the battery or power component when the battery or power component is installed.

Another aspect of the disclosed embodiments includes a system for securing a battery or power component. The system comprises: a battery or power component enclosure comprising a front access configured to facilitate access to the battery or power component and a first shelf sub-assembly comprising a first shelf body comprising a two-sided configuration where a first side of the first shelf body is perpendicular to a second side of the first shelf body, where the first side of the first shelf body is attachable to a first interior side of the power component and battery enclosure, and where the second side of the first shelf body extends substantially horizontally relative to the first side of the first shelf body when the first side of the first shelf body is attached to the first interior side and provides a substantially level surface upon which a bottom surface of the battery or a bottom surface of a power component is placed when installed. The first shelf sub-assembly further comprises a first leaf spring component attachable to the first side of the first shelf body, where the first leaf spring component comprises a first radiused surface configured to apply a first compressive force against a first lateral surface of the battery or power component when the battery or power component is installed and a second shelf sub-assembly comprising a second shelf body comprising a two-sided configuration where a first side of the second shelf body is perpendicular to a second side of the second shelf body, where the first side of the second shelf body is attachable to a second interior side of the power component and battery enclosure, and where the second side of the second shelf body extends substantially horizontally relative to the first side of the second shelf body when the first side of the second shelf body is attached to the second interior side and provides a substantially level surface upon which the bottom surface of the battery or the bottom surface of the power component is placed when installed. The second shelf sub-assembly further comprises a second leaf spring component attachable to the first side of the second shelf body, where the second leaf spring component comprising a second radiused surface configured to apply a second compressive force against a second lateral surface of the battery or power component when the battery or power component is installed.

These and other aspects of the present disclosure are disclosed in the following detailed description of the embodiments, the appended claims, and the accompanying figures.

### BRIEF DESCRIPTION OF THE DRAWINGS

The disclosure is best understood from the following detailed description when read in conjunction with the accompanying drawings. It is emphasized that, according to common practice, the various features of the drawings are not to scale. On the contrary, the dimensions of the various features are arbitrarily expanded or reduced for clarity.
FIG. 1 generally illustrates a front-side perspective view of a power component and battery enclosure, according to the principles of the present disclosure.
FIG. 2 generally illustrates a rear-side perspective view of a power component and battery enclosure, according to the principles of the present disclosure.
FIGS. 3A and 3B generally illustrate a front right side perspective view and a front left side perspective view of a power component and battery enclosure, according to the principles of the present disclosure.
FIGS. 4A and 4B generally illustrate a left battery shelf sub-assembly and a right battery shelf sub-assembly, according to the principles of the present disclosure.
FIGS. 5A-8 generally illustrate the installation process of a battery or power component in an enclosure, according to the principles of the present disclosure.

Those skilled in the art will appreciate and understand that, according to common practice, various features of the drawings discussed below are not necessarily drawn to scale, and that dimensions of various features and elements of the drawings may be expanded or reduced to more clearly illustrate the embodiments of the present disclosure described herein.

### DETAILED DESCRIPTION

The following discussion is directed to various embodiments of the disclosure. Although one or more of these embodiments may be preferred, the embodiments disclosed should not be interpreted, or otherwise used, as limiting the scope of the disclosure, including the claims. In addition, one skilled in the art will understand that the following description has broad application, and the discussion of any embodiment is meant only to be exemplary of that embodiment, and not intended to intimate that the scope of the disclosure, including the claims, is limited to that embodiment.

The present specification and accompanying drawings disclose one or more embodiments that incorporate the features of the present disclosure. The scope of the present disclosure is not limited to the disclosed embodiments. The disclosed embodiments merely exemplify the present disclosure, and modified versions of the disclosed embodiments are also encompassed by the present disclosure. Embodiments of the present disclosure are defined by the claims appended hereto.

References in the specification to "one embodiment," "an embodiment," "an example embodiment," etc., indicate that the embodiment described may include a particular feature, structure, or characteristic, but every embodiment may not necessarily include the particular feature, structure, or characteristic. Moreover, such phrases are not necessarily referring to the same embodiment. Further, when a particular feature, structure, or characteristic is described in connection with an embodiment, it is submitted that it is within the knowledge of one skilled in the art to effect such feature, structure, or characteristic in connection with other embodiments whether or not explicitly described.

In the discussion, unless otherwise stated, adjectives such as "substantially," "approximately," and "about" modifying a condition or relationship characteristic of a feature or features of an embodiment of the disclosure, are understood to mean that the condition or characteristic is defined to be within tolerances that are acceptable for operation of the embodiment for an application for which it is intended.

Furthermore, it should be understood that spatial descriptions (e.g., "above," "below," "up," "left," "right," "down," "top," "bottom," "vertical," "horizontal," etc.) used herein are for purposes of illustration only, and that practical implementations of the structures described herein can be spatially arranged in any orientation or manner.

The word "example" is used herein to mean serving as an example, instance, or illustration. Any aspect or design described herein as "example" is not necessarily to be construed as preferred or advantageous over other aspects or designs. Rather, use of the word "example" is intended to present concepts in a concrete fashion. As used in this application, the term "or" is intended to mean an inclusive "or" rather than an exclusive "or." That is, unless specified otherwise, or clear from context, "X includes A or B" is intended to mean any of the natural inclusive permutations. That is, if X includes A; X includes B; or X includes both A and B, then "X includes A or B" is satisfied under any of the foregoing instances. In addition, the articles "a" and "an" as used in this application and the appended claims should generally be construed to mean "one or more" unless specified otherwise or clear from context to be directed to a singular form. Moreover, use of the term "an implementation" or "one implementation" throughout is not intended to mean the same embodiment or implementation unless described as such.

Numerous exemplary embodiments are described as follows. It is noted that any section/subsection headings provided herein are not intended to be limiting. Embodiments are described throughout this document, and any type of embodiment may be included under any section/subsection. Furthermore, embodiments disclosed in any section/subsection may be combined with any other embodiments described in the same section/subsection and/or a different section/subsection in any manner.

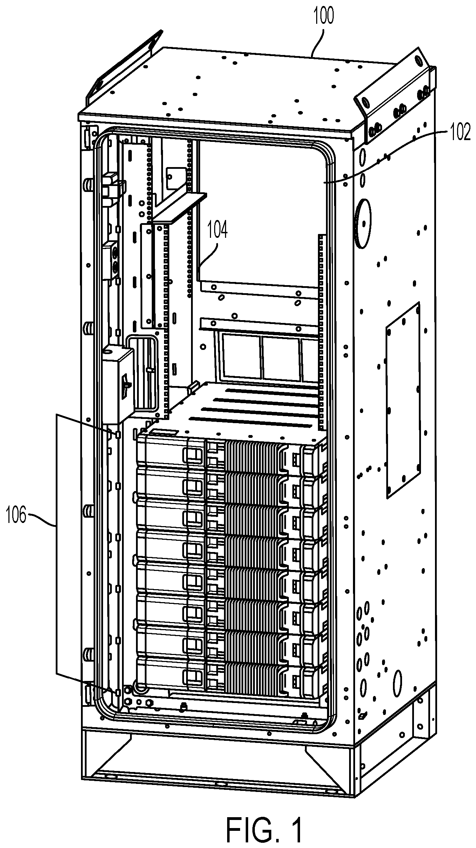

FIGS. 1-8 provide different perspective views of a power component and battery enclosure, in accordance with embodiments described herein. FIG. 1 illustrates a front-side perspective view of a battery or power component enclosure 100 (also interchangeably referred to as "enclosure" hereinafter) configured for modularity and secure installation of battery or power components, such as power supply units and electronic devices. As shown in FIG. 1, the enclosure 100 includes a front access 102 and an upper rear access 104. The front access 102 and the upper rear access 104 may provide accessibility to components secured within the enclosure 100. Additionally, the front access 102 and the upper rear access 104 may facilitate installation of and replacement of components within the enclosure 100.

As depicted in FIG. 1, inside the enclosure 100, a plurality of battery or power components 106 (e.g., lithium-ion batteries) are arranged in a stacked configuration. As further depicted in FIG. 1, the plurality of battery or power components 106 (also interchangeably referred to as "component" herein) are placed within the enclosure 100 below the upper rear access 104. As such, the plurality of components 106 may be inserted into the enclosure 100 from the front access 102.

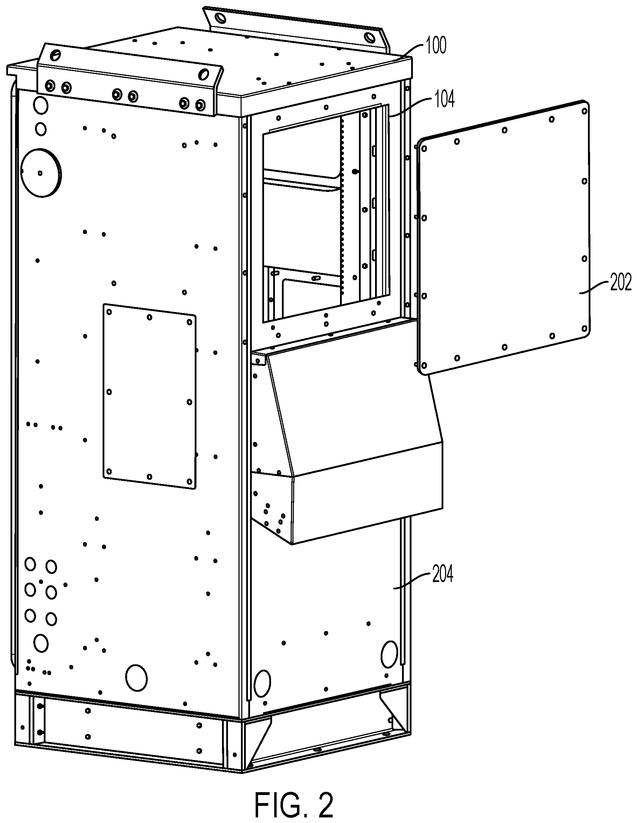

FIG. 2 provides a rear-side perspective view of the enclosure 100 depicted in FIG. 1. More specifically, FIG. 2 provides an exploded view of an upper rear access panel 202. The upper rear access panel 202 may be configured to fit over the upper rear access 104. In some embodiments, the upper rear access panel 202 may be secured to a backside of the enclosure 100 via mechanical fasteners (e.g., such as nuts and bolts, machine screws, or sheet metal screws in conjunction with lock washers).

As depicted in FIG. 2, the upper rear access 104 is positioned in an upper section of a rear panel 204 of the enclosure 100. This allows for access to certain components while keeping other components in more secured areas of the enclosure 100, such as a lower section of the rear panel 204 of the enclosure 100. As further depicted in FIG. 2, the lower section of the rear panel 204 of the enclosure 100 is primarily solid. Thus, components secured in the enclosure 100 below the upper rear access 104 are not accessible from the rear of the enclosure 100.

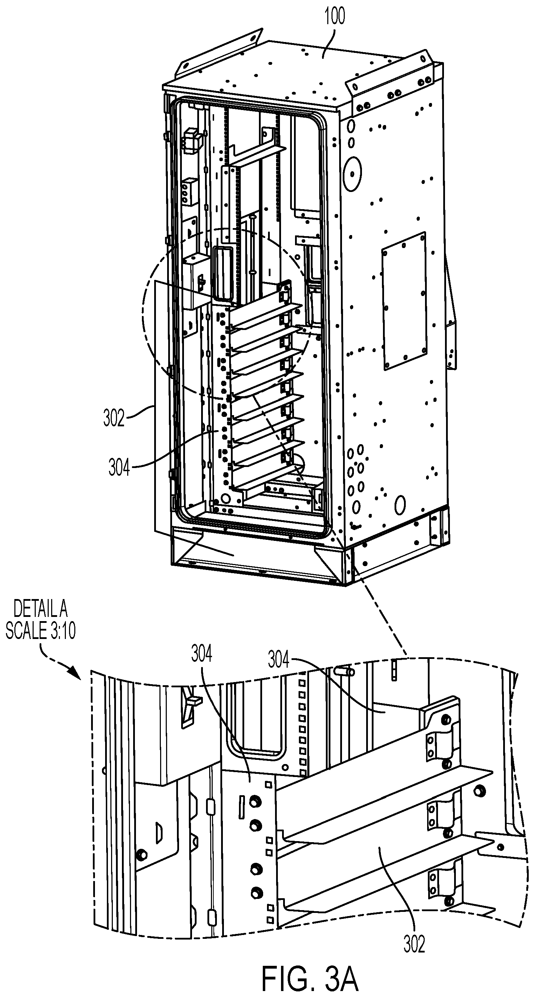

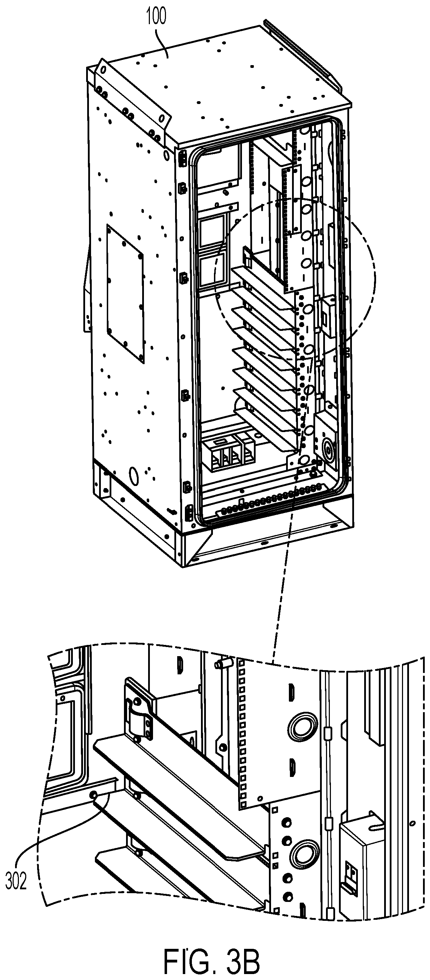

FIGS. 3A and 3B illustrate a front right side perspective view and a front left side perspective view of the enclosure 100 depicted in FIGS. 1 and 2. In particular, FIGS. 3A and 3B depict the enclosure 100 without components mounted in the interior of the enclosure 100 and a plurality of battery shelf sub-assemblies 302 secured to left and right sides of the enclosure 100. In FIGS. 3A and 3B, each battery shelf sub-assembly of the plurality of battery shelf sub-assemblies 302 is aligned vertically on the left and right side of the enclosure 100. A pair of battery shelf sub-assemblies of the plurality of battery shelf sub-assemblies 302, situated opposite each other on the left and right sides of the enclosure 100 may be used for securing components (such as lithium-ion batteries) within the enclosure 100.

In some embodiments, as shown in FIGS. 3A and 3B, the plurality of battery shelf sub-assemblies 302 are secured to an internal frame structure 304 at the front and rear of the enclosure 100 via mechanical fasteners. FIGS. 3A and 3B provide an enlarged, detailed view of a set of battery shelf sub-assemblies 302 of the plurality of battery shelf sub-assemblies 302 secured to the internal frame structure 304.

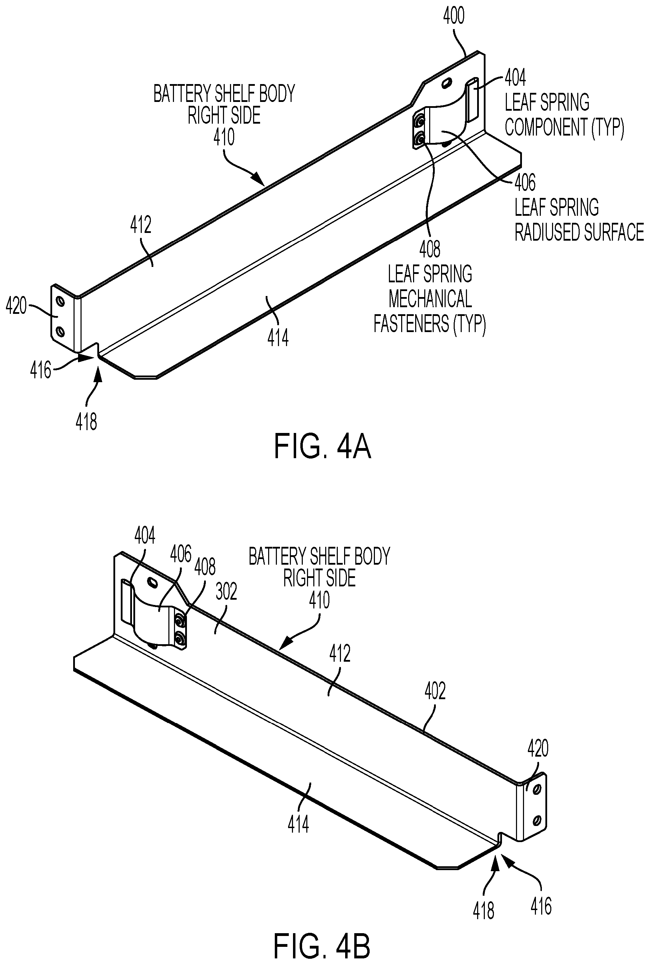

FIGS. 4A and 4B illustrate a left battery shelf sub-assembly 400 and a right battery shelf sub-assembly 402, respectively, and elements of the left battery shelf sub-assembly 400 and the right battery shelf sub-assembly 402. As shown in FIGS. 4A and 4B, the left battery shelf sub-assembly 400 and the right battery shelf sub-assembly 402 both include a leaf spring component 404, a leaf spring fastener 408, and a shelf body 410.

As further shown in FIGS. 4A and 4B, the leaf spring component 404 includes the leaf spring radiused surface 406, which has a rounded form. The leaf spring radiused surface 406 includes a curved or radius form along part of its length that serves as a spring. In some embodiments, the leaf spring radiused surface 406 may be a flat strip or several strips of metal layered on top of one another. The leaf spring radiused surface 406 may be configured to bend under load and return to its original shape when the load is removed.

The leaf spring fastener 408 may be configured to secure the leaf spring component 404 to the rear portion of the shelf body 410 of the left battery shelf sub-assembly 400 and the right battery shelf sub-assembly 402. In some embodiments, the leaf spring fastener 408 may comprise mechanical fasteners.

The shelf body 410 may comprise a two-sided configuration where a first side 412 of the shelf body 410 is perpendicular to a second side 414 of the shelf body 410, and the first side 412 and the second side 414 intersect at a first edge 416 of the first side 412 and a second edge 418 of the second side 414. The first side 412 may be attachable to the power component and battery enclosure 100. The second side 414 may extend substantially horizontally relative to the first side 412 when the first side 412 is attached to the interior of the power component and battery enclosure 100 and may provide a substantially level surface (e.g., a flat and even surface) upon which a bottom surface of a battery or a bottom surface of a power component (e.g., a component of the plurality of components 106) may be placed. The leaf spring component 404 may be attachable to the first side 412 of the shelf body 410. In some embodiments, the first side 412 and the second side 414 are substantially flat (e.g., smooth and even plane with a uniform level). In some embodiments, the shelf body 410 forms an L-shaped profile when viewed from an end of the shelf body 410.

The leaf spring radiused surface 406 may be configured to engage a lateral surface of the battery or power component and apply a compressive force against the lateral surface to enable securing the battery or power component within the enclosure 100. For example, the left battery shelf sub-assembly 400 and the right battery shelf sub-assembly 402 are configured to engage components when placed between the left battery shelf sub-assembly 400 and the right battery shelf sub-assembly 402 via the leaf spring radiused surface 406. More specifically, when a component is inserted into the enclosure 100 and arranged between the left battery shelf sub-assembly 400 and the right battery shelf sub-assembly 402, the leaf spring radiused surface 406 of the left battery shelf sub-assembly 400 and the right battery shelf sub-assembly 402 are compressed by lateral sides of the component, creating a stable contact force between the leaf spring radiused surfaces 406 and the lateral sides of the component.

Once the battery shelf sub-assemblies are mounted in the enclosure 100, the distance spanning from one leaf spring radiused surface 406 to its counterpart across the enclosure 100 is narrower than the span required for width of a component, ensuring a secure fit of the component as the leaf spring radiused surface 406 of the left battery shelf sub-assembly 400 and the right battery shelf sub-assembly 402 exerts pressure on opposing lateral sides of a housing on the component.

As shown in FIGS. 4A and 4B, the leaf spring component 404 may be attached to the first side 412 of the shelf body 410 at a position proximate to an end of the shelf body that is closer to a back interior wall of the power component and battery enclosure 100 than an opposing end of the shelf body 410 which is proximate the front access 102 when the shelf sub-assembly is installed within the power component and battery enclosure 100.

In some embodiments, the left battery shelf sub-assembly 400 and the right battery shelf sub-assembly 402 can be made from one or more different materials (e.g., plastic, metal, etc.) dependent on the application. More specifically, in some embodiments, the left battery shelf sub-assembly 400 and the right battery shelf sub-assembly 402 may be made the from sturdy 14-gauge steel. In some embodiments, the leaf spring component 404 may be made from 20-gauge spring steel.

In some embodiments, the leaf spring radiused surface 406 is further configured to adapt to accommodate dimensional variances of different types of battery or power components. For example, the leaf spring radiused surface 406 may be configured to be flexible, allowing it to bend to accommodate a component when it is installed. Once the component is uninstalled, the leaf spring radiused surface 406 returns to its original shape.

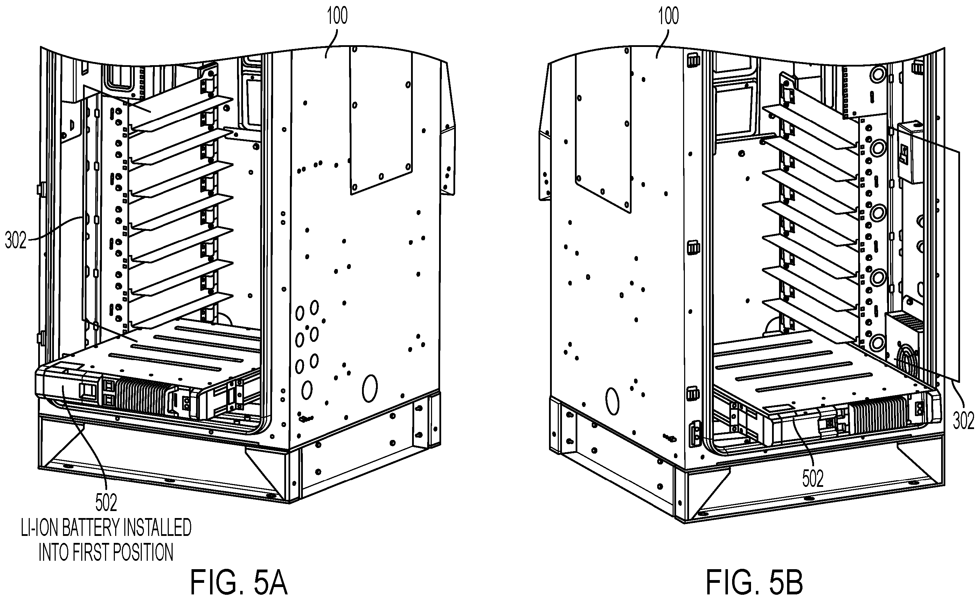

FIGS. 5A-8 will now be described to help illustrate the installation process of a component in an enclosure. As depicted in FIGS. 5A and 5B, a component 502 is placed between a left battery shelf sub-assembly and a right battery shelf sub-assembly of the plurality of battery shelf sub-assemblies 302, installed within the enclosure 100.

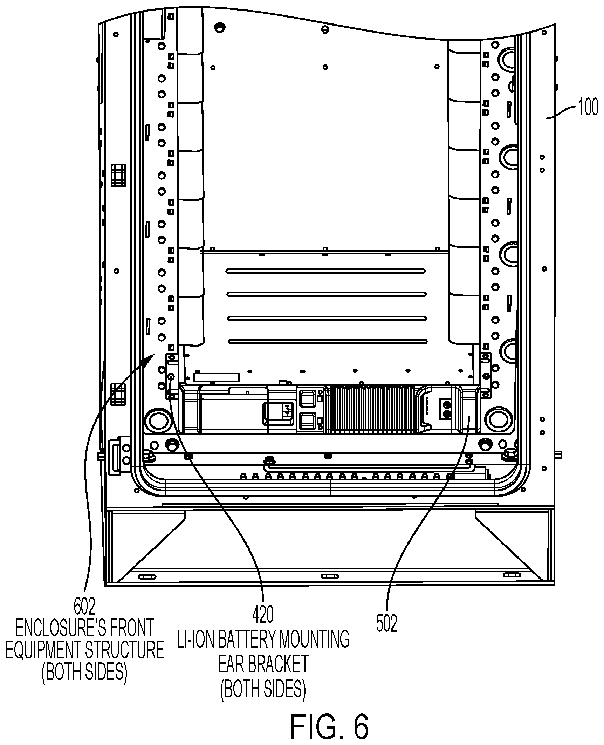

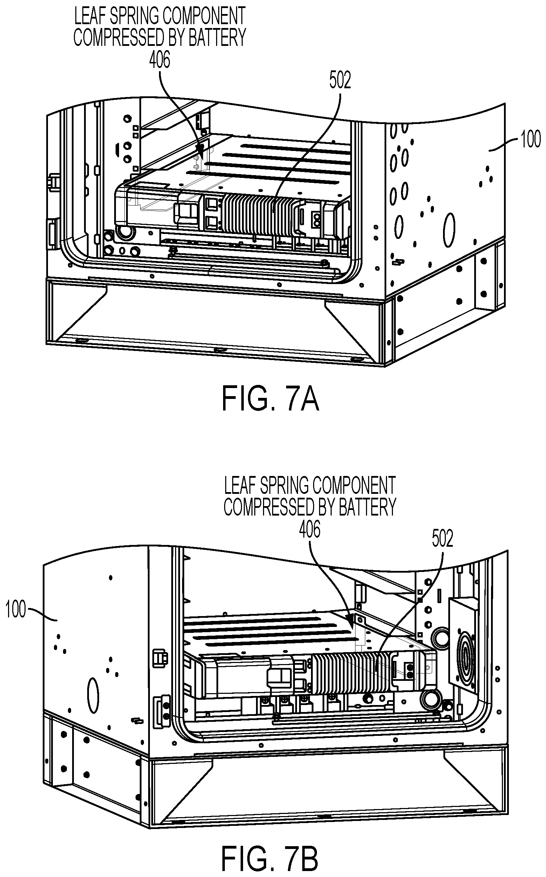

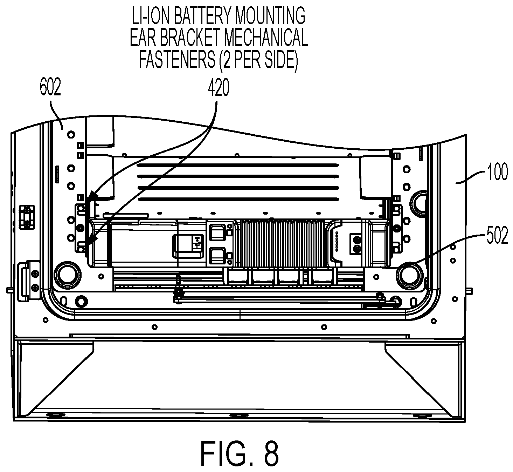

As shown in FIG. 6, the component 502 may be installed by sliding the component into battery shelf sub-assemblies until the mounting ear brackets 420 interface with a front equipment structure 602 of the enclosure 100. During this process, each lateral side of the component 502 engages with the leaf spring radiused surface 406. This engagement presses the leaf spring radiused surface 406, establishing a firm contact force between the battery shelf sub-assemblies and the lateral surfaces of the component 502, as shown in FIGS 7A and 7B. Additionally, to secure the component 502, the mounting ear brackets 420 may be fastened to a front equipment structure 602 of the enclosure 100, as depicted in FIG. 8.

One benefit of the embodiments disclosed herein is that components mounted in an enclosure compliant with Electronic Industries Alliance (EIA) rack standards require some form of restraint at the rear of the components to mitigate potential movement. For example, the use of mechanical fasteners to secure or restrain components at the rear of a front access only enclosure would not be practical as access to these fasteners would not be possible because of the front access only configuration. Utilizing a latch system is also not a viable option because the latch system would have to allow the user to be able to release or "open" a latch located at the rear of the enclosure from the front access of the enclosure. The component restraint features disclosed herein provide the necessary restraint at the rear of a component, without the user needing to access the rear of the enclosure.

Another benefit of the embodiments disclosed herein is that the component restraint features utilized at the rear of an enclosure are passive in nature, thus do not prevent or overly constrain the ability of the user to remove or replace the component within the enclosure. This allows the user to remove any component within a stack of components. While the use of mechanical fasteners or active latches at the rear of the enclosure may be feasible during component installation, once the entire component stack is installed, removing a specific component within the stack would not be feasible without removing every component above it.

Still yet, another benefit of the component restraint feature disclosed is that it is flexible and is configured to interface with various component types and styles and address typical manufacturing tolerances.

Embodiments disclosed herein provide sufficient restraint of components at its front via fastening of the mounting ear brackets of the shelf sub-assembly to a front frame of the enclosure, which is consistent with typical EIA rack standards. At the rear of the component, the contact force created between the leaf spring component and lateral side surfaces of the component are able to keep the component from excessive undesired movement during any kind of seismic event, which could lead to elevated stresses seen in the enclosure's components and other detrimental consequences.

Further, the radiused surface of the leaf spring component serves as a lead-in when a component engages it. As previously mentioned, the opposing side-to-side span between the leaf spring components is less than the side-to-side span of a component, such as a lithium-ion battery. During this engagement, the leaf spring components are able to deflect down to the side-to-side span of the component and create the contact force between leaf spring components and the lateral side of the component that restrains the component at the rear of the enclosure.

To remove the component, the user would first disassemble the mounting ear bracket fasteners at the front of the enclosure, and then apply enough "pull-out" force on the component that will overcome the aforementioned contact force between the leaf spring components and component side walls. For example, target deflection amount for the leaf spring component is small (e.g., approximately 3/16"). Manufacturing tolerances are also expected to be small (e.g., approximately +- 1/16"). The leaf spring component material (e.g., 20 Ga Spring Steel) is configured to endure the target deflection and its tolerance range without yielding. Note that that the specific measurements or configurations of the leaf spring component are easily adapted to accommodate different types of components being used (e.g., based on the size and weight of the component), as well as achieving the contact force that will have a proper balance between restraining the component at the rear of the enclosure while allowing the user the ease of removal of the component when necessary. Maintaining this operation within the leaf spring component's yield strength allows the proper balance to be achieved.

In some embodiments, a shelf sub-assembly configured to accommodate a battery or power component upon installation, the shelf sub-assembly comprises: a shelf body comprising a two-sided configuration where a first side of the shelf body is perpendicular to a second side of the shelf body and the first side and the second side intersect at a first edge of the first side and a second edge of the second side, wherein the first side is attachable to an interior of a power component and battery enclosure, and wherein the second side extends substantially horizontally relative to the first side when the first side is attached to the interior of the power component and battery enclosure and provides a substantially level surface upon which a bottom surface of a battery or a bottom surface of a power component is placed when installed; and a leaf spring component attachable to the first side of the shelf body, the leaf spring component comprising a radiused surface configured to engage a lateral surface of the battery or power component and apply a compressive force against the lateral surface when the battery or power component is installed.

In some embodiments, the first side is secured to the interior of the power component and battery enclosure via mechanical fasteners.

In some embodiments, the first side is substantially flat.

In some embodiments, the second side is substantially flat.

In some embodiments, the leaf spring component is attached to the first side of the shelf body at a position proximate to an end of the shelf body, the end being closer to a back interior wall of the power component and battery enclosure than the an opposing end of the shelf body.

In some embodiments, the first side is attached to the interior of the power component and battery enclosure at the end and the opposing end of the shelf body.

In some embodiments, the first side is secured to the interior of the power component and battery enclosure at the end and the opposing end of the shelf body via mechanical fasteners.

In some embodiments, the leaf spring component is attached to the first side via mechanical fasteners.

In some embodiments, the radiused surface is further configured to accommodate dimensional variances of different types of battery or power components.

In some embodiments, the shelf body forms an L-shaped profile.

In some embodiments, a system for securing a battery or power component within a battery and power component enclosure, the system comprises: a first shelf sub-assembly comprising: a first shelf body comprising a two-sided configuration where a first side of the first shelf body is perpendicular to a second side of the first shelf body, wherein the first side of the first shelf body is attachable to a first interior side of the power component and battery enclosure, and wherein the second side of the first shelf body extends substantially horizontally relative to the first side of the first shelf body when the first side of the first shelf body is attached to the first interior side and provides a substantially level surface upon which a bottom surface of a battery or a bottom surface of a power component is placed when installed; and a first leaf spring component attachable to the first side of the first shelf body, the first leaf spring component comprising a first radiused surface configured to apply a first compressive force against a first lateral surface of the battery or power component when the battery or power component is installed; and a second shelf sub-assembly comprising: a second shelf body comprising a two-sided configuration where a first side of the second shelf body is perpendicular to a second side of the second shelf body, wherein the first side of the second shelf body is attachable to a second interior side of the power component and battery enclosure, and wherein the second side of the second shelf body extends substantially horizontally relative to the first side of the second shelf body when the first side of the second shelf body is attached to the second interior side and provides a substantially level surface upon which the bottom surface of the battery or the bottom surface of the power component is placed when installed; and a second leaf spring component attachable to the first side of the second shelf body, the second leaf spring component comprising a second radiused surface configured to apply a second compressive force against a second lateral surface of the battery or power component when the battery or power component is installed.

**In** some embodiments, the first side of the first shelf body is attached to the first interior side of the power component and battery enclosure via mechanical fasteners.

**In** some embodiments, the first side of the second shelf body is attached to the second interior side of the power component and battery enclosure via mechanical fasteners.

**In** some embodiments, the first leaf spring component is attached to the first side of the first shelf body via mechanical fasteners.

**In** some embodiments, the second leaf spring component is attached to the first side of the second shelf body via mechanical fasteners.

In some embodiments, the first radiused surface is further configured to adapt to accommodate dimensional variances of different types of battery or power components.

In some embodiments, the second radiused surface is further configured to adapt to accommodate dimensional variances of different types of battery or power components.

In some embodiments, a system for securing a battery or power component, the system comprises: a battery or power component enclosure comprising a front access configured to facilitate access to the battery or power component; a first shelf sub-assembly comprising: a first shelf body comprising a two-sided configuration where a first side of the first shelf body is perpendicular to a second side of the first shelf body, wherein the first side of the first shelf body is attachable to a first interior side of the power component and battery enclosure, and wherein the second side of the first shelf body extends substantially horizontally relative to the first side of the first shelf body when the first side of the first shelf body is attached to the first interior side and provides a substantially level surface upon which a bottom surface of the battery or a bottom surface of a power component is placed when installed; and a first leaf spring component attachable to the first side of the first shelf body, the first leaf spring component comprising a first radiused surface configured to apply a first compressive force against a first lateral surface of the battery or power component when the battery or power component is installed; and a second shelf sub-assembly comprising: a second shelf body comprising a two-sided configuration where a first side of the second shelf body is perpendicular to a second side of the second shelf body, wherein the first side of the second shelf body is attachable to a second interior side of the power component and battery enclosure, and wherein the second side of the second shelf body extends substantially horizontally relative to the first side of the second shelf body when the first side of the second shelf body is attached to the second interior side and provides a substantially level surface upon which the bottom surface of the battery or the bottom surface of the power component is placed when installed; and a second leaf spring component attachable to the first side of the second shelf body, the second leaf spring component comprising a second radiused surface configured to apply a second compressive force against a second lateral surface of the battery or power component when the battery or power component is installed.

In some embodiments, the first leaf spring component is attached to the first side of the first shelf body at a position proximate to an end of the first shelf body, the end being closer to a back interior wall of the power component and battery enclosure than an opposing end of the first shelf body which is closer to the front access of the power component and battery enclosure.

In some embodiments, the second leaf spring component is attached to the first side of the second shelf body at a position proximate to an end of the second shelf body, the end being closer to a back interior wall of the power component and battery enclosure than an opposing end of the second shelf body which is closer to the front access of the power component and battery enclosure.

Implementations the systems, algorithms, methods, instructions, etc., described herein can be realized in hardware, software, or any combination thereof. The hardware can include, for example, computers, intellectual property (IP) cores, application-specific integrated circuits (ASICs), programmable logic arrays, optical processors, programmable logic controllers, microcode, microcontrollers, servers, microprocessors, digital signal processors, or any other suitable circuit. In the claims, the term "processor" should be understood as encompassing any of the foregoing hardware, either singly or in combination. The terms "signal" and "data" are used interchangeably.

As used herein, the term module can include a packaged functional hardware unit designed for use with other components, a set of instructions executable by a controller (e.g., a processor executing software or firmware), processing circuitry configured to perform a particular function, and a self-contained hardware or software component that interfaces with a larger system. For example, a module can include an application specific integrated circuit (ASIC), a Field Programmable Gate Array (FPGA), a circuit, digital logic circuit, an analog circuit, a combination of discrete circuits, gates, and other types of hardware or combination thereof. In other embodiments, a module can include memory that stores instructions executable by a controller to implement a feature of the module.

Further, in one aspect, for example, systems described herein can be implemented using a general-purpose computer or general-purpose processor with a computer program that, when executed, carries out any of the respective methods, algorithms, and/or instructions described herein. In addition, or alternatively, for example, a special purpose computer/processor can be utilized which can contain other hardware for carrying out any of the methods, algorithms, or instructions described herein.

Further, all or a portion of implementations of the present disclosure can take the form of a computer program product accessible from, for example, a computer-usable or computer-readable medium. A computer-usable or computer-readable medium can be any device that can, for example, tangibly contain, store, communicate, or transport the program for use by or in connection with any processor. The medium can be, for example, an electronic, magnetic, optical, electromagnetic, or a semiconductor device. Other suitable mediums are also available.

The above-described embodiments, implementations, and aspects have been described in order to allow easy understanding of the present disclosure and do not limit the present disclosure. On the contrary, the disclosure is intended to cover various modifications and equivalent arrangements included within the scope of the appended claims, which scope is to be accorded the broadest interpretation to encompass all such modifications and equivalent structure as is permitted under the law.
The disclosure comprises the following items:
1. A shelf sub-assembly configured to accommodate a battery or power component upon installation, the shelf sub-assembly comprising:
   a shelf body comprising a two-sided configuration where a first side of the shelf body is perpendicular to a second side of the shelf body and the first side and the second side intersect at a first edge of the first side and a second edge of the second side, wherein the first side is attachable to an interior of a power component and battery enclosure, and wherein the second side extends substantially horizontally relative to the first side when the first side is attached to the interior of the power component and battery enclosure and provides a substantially level surface upon which a bottom surface of a battery or a bottom surface of a power component is placed when installed; and
   a leaf spring component attachable to the first side of the shelf body, the leaf spring component comprising a radiused surface configured to engage a lateral surface of the battery or power component and apply a compressive force against the lateral surface when the battery or power component is installed.
2. The shelf sub-assembly of item 1, wherein the first side is secured to the interior of the power component and battery enclosure via mechanical fasteners.
3. The shelf sub-assembly of item 1 or item 2, wherein the first side is substantially flat.
4. The shelf sub-assembly of any preceding item, wherein the second side is substantially flat.
5. The shelf sub-assembly of any preceding item, wherein the leaf spring component is attached to the first side of the shelf body at a position proximate to an end of the shelf body, the end being closer to a back interior wall of the power component and battery enclosure than the an opposing end of the shelf body.
6. The shelf sub-assembly of any preceding item, wherein the first side is attached to the interior of the power component and battery enclosure at the end and the opposing end of the shelf body.
7. The shelf sub-assembly of any preceding item, wherein the first side is secured to the interior of the power component and battery enclosure at the end and the opposing end of the shelf body via mechanical fasteners.
8. The shelf sub-assembly of any preceding item, wherein the leaf spring component is attached to the first side via mechanical fasteners.
9. The shelf sub-assembly of any preceding item, wherein the radiused surface is further configured to accommodate dimensional variances of different types of battery or power components.
10. The shelf sub-assembly of any preceding item, wherein the shelf body forms an L-shaped profile.
11. A system for securing a battery or power component within a battery and power component enclosure, the system comprising:
   a first shelf sub-assembly comprising:
      a first shelf body comprising a two-sided configuration where a first side of the first shelf body is perpendicular to a second side of the first shelf body, wherein the first side of the first shelf body is attachable to a first interior side of the power component and battery enclosure, and wherein the second side of the first shelf body extends substantially horizontally relative to the first side of the first shelf body when the first side of the first shelf body is attached to the first interior side and provides a substantially level surface upon which a bottom surface of a battery or a bottom surface of a power component is placed when installed; and
      a first leaf spring component attachable to the first side of the first shelf body, the first leaf spring component comprising a first radiused surface configured to apply a first compressive force against a first lateral surface of the battery or power component when the battery or power component is installed; and
   a second shelf sub-assembly comprising:
      a second shelf body comprising a two-sided configuration where a first side of the second shelf body is perpendicular to a second side of the second shelf body, wherein the first side of the second shelf body is attachable to a second interior side of the power component and battery enclosure, and wherein the second side of the second shelf body extends substantially horizontally relative to the first side of the second shelf body when the first side of the second shelf body is attached to the second interior side and provides a substantially level surface upon which the bottom surface of the battery or the bottom surface of the power component is placed when installed; and
      a second leaf spring component attachable to the first side of the second shelf body, the second leaf spring component comprising a second radiused surface configured to apply a second compressive force against a second lateral surface of the battery or power component when the battery or power component is installed.
12. The system of item 11, wherein the first side of the first shelf body is attached to the first interior side of the power component and battery enclosure via mechanical fasteners.
13. The system of item 11 or item 12, wherein the first side of the second shelf body is attached to the second interior side of the power component and battery enclosure via mechanical fasteners.
14. The system of any of items 11-13, wherein the first leaf spring component is attached to the first side of the first shelf body via mechanical fasteners.
15. The system of any of items 11-14, wherein the second leaf spring component is attached to the first side of the second shelf body via mechanical fasteners.
16. The system of any of items 11-15, wherein the first radiused surface is further configured to adapt to accommodate dimensional variances of different types of battery or power components.
17. The system of any of items 11-16, wherein the second radiused surface is further configured to adapt to accommodate dimensional variances of different types of battery or power components.
18. A system for securing a battery or power component, the system comprising:
   a battery or power component enclosure comprising a front access configured to facilitate access to the battery or power component;
   a first shelf sub-assembly comprising:
      a first shelf body comprising a two-sided configuration where a first side of the first shelf body is perpendicular to a second side of the first shelf body, wherein the first side of the first shelf body is attachable to a first interior side of the power component and battery enclosure, and wherein the second side of the first shelf body extends substantially horizontally relative to the first side of the first shelf body when the first side of the first shelf body is attached to the first interior side and provides a substantially level surface upon which a bottom surface of the battery or a bottom surface of a power component is placed when installed; and
      a first leaf spring component attachable to the first side of the first shelf body, the first leaf spring component comprising a first radiused surface configured to apply a first compressive force against a first lateral surface of the battery or power component when the battery or power component is installed; and
   a second shelf sub-assembly comprising:
      a second shelf body comprising a two-sided configuration where a first side of the second shelf body is perpendicular to a second side of the second shelf body, wherein the first side of the second shelf body is attachable to a second interior side of the power component and battery enclosure, and wherein the second side of the second shelf body extends substantially horizontally relative to the first side of the second shelf body when the first side of the second shelf body is attached to the second interior side and provides a substantially level surface upon which the bottom surface of the battery or the bottom surface of the power component is placed when installed; and
      a second leaf spring component attachable to the first side of the second shelf body, the second leaf spring component comprising a second radiused surface configured to apply a second compressive force against a second lateral surface of the battery or power component when the battery or power component is installed.
19. The system of item 18, wherein the first leaf spring component is attached to the first side of the first shelf body at a position proximate to an end of the first shelf body, the end being closer to a back interior wall of the power component and battery enclosure than an opposing end of the first shelf body which is closer to the front access of the power component and battery enclosure.
20. The system of item 18 or item 19, wherein the second leaf spring component is attached to the first side of the second shelf body at a position proximate to an end of the second shelf body, the end being closer to a back interior wall of the power component and battery enclosure than an opposing end of the second shelf body which is closer to the front access of the power component and battery enclosure.

## Claims

1. A shelf sub-assembly configured to accommodate a battery or power component upon installation, the shelf sub-assembly comprising:
a shelf body comprising a two-sided configuration where a first side of the shelf body is perpendicular to a second side of the shelf body and the first side and the second side intersect at a first edge of the first side and a second edge of the second side, wherein the first side is attachable to an interior of a power component and battery enclosure, and wherein the second side extends substantially horizontally relative to the first side when the first side is attached to the interior of the power component and battery enclosure and provides a substantially level surface upon which a bottom surface of a battery or a bottom surface of a power component is placed when installed; and
a leaf spring component attachable to the first side of the shelf body, the leaf spring component comprising a radiused surface configured to engage a lateral surface of the battery or power component and apply a compressive force against the lateral surface when the battery or power component is installed.

2. The shelf sub-assembly of claim 1, wherein the first side is secured to the interior of the power component and battery enclosure via mechanical fasteners.

3. The shelf sub-assembly of claim 1 or claim 2, wherein the first side is substantially flat.

4. The shelf sub-assembly of any preceding claim, wherein the second side is substantially flat.

5. The shelf sub-assembly of any preceding claim, wherein the leaf spring component is attached to the first side of the shelf body at a position proximate to an end of the shelf body, the end being closer to a back interior wall of the power component and battery enclosure than the an opposing end of the shelf body.

6. The shelf sub-assembly of claim 5, wherein the first side is attached to the interior of the power component and battery enclosure at the end and the opposing end of the shelf body.

7. The shelf sub-assembly of claim 6, wherein the first side is secured to the interior of the power component and battery enclosure at the end and the opposing end of the shelf body via mechanical fasteners.

8. The shelf sub-assembly of any preceding claim, wherein the leaf spring component is attached to the first side via mechanical fasteners.

9. The shelf sub-assembly of any preceding claim, wherein the radiused surface is further configured to accommodate dimensional variances of different types of battery or power components.

10. The shelf sub-assembly of any preceding claim, wherein the shelf body forms an **L-**shaped profile.

11. A system for securing a battery or power component within a battery and power component enclosure, the system comprising:
a first shelf sub-assembly comprising the features of any preceding claim; and
a second shelf sub-assembly comprising the features of any preceding claim.

12. A system for securing a battery or power component, the system comprising:
a battery or power component enclosure comprising a front access configured to facilitate access to the battery or power component; and
the system for securing a battery or power component of claim 11.
